# EUROPÄISCHE PATENTANMELDUNG

(11) **EP 0 693 775 A2**
(43) Veröffentlichungstag der Anmeldung: **24.01.1996**
(21) Anmeldenummer: 95110286.2
(22) Anmeldetag: 30.06.1995
(51) Int. Cl.: H01L 21/8248

(54) **Verfahren zur Herstellung von MOS-Transistoren und Bipolartransistoren auf einer Halbleiterscheibe**

(30) Priorität: 12.07.1994 DE 4424557
(71) Anmelder: SIEMENS AKTIENGESELLSCHAFT, D-80333 München (DE)
(72) Erfinder: Müller, Karl Heinz, D-84478 Waldkraiburg (DE)

(57) **Zusammenfassung**

Zur Verbesserung des Herstellverfahrens einer Vorrichtung mit MOS- und Bipolartransistoren wird vorgeschlagen, daß nach der Herstellung bis auf die Oberfläche der Halbleiterscheibe gehender Öffnungen und eines allseitig isolierten Gatebereichs (6) ganzflächig eine amorphe Siliziumschicht (10) aufgebracht, dotiert und rekristallisiert wird und daß nach dem Aufbringen einer Hilfsschicht (11, 12) letztere und die Siliziumschicht (10) strukturiert werden. Es ist vorgesehen, daß diese und ggf. weitere strukturierte Siliziumschichten (23) die jeweils gegeneinander isoliert sind, ebenso wie Fenster der Gatebereiche(6) freigelegt und siliziert werden. Dadurch lassen sich niederohmige zuverlässige Anschlüsse aktiver und passiver Elemente der Vorrichtung mit geringem Aufwand an Masken erzeugen.

## Beschreibung

Die Erfindung betrifft ein Verfahren zur Herstellung von komplementären MOS-Transistoren und von komplementären Bipolartransistoren auf einer gemeinsamen Halbleiterscheibe, bei dem vergrabene Zonen unterschiedlicher Leitfähigkeit erzeugt werden, bei dem n- und p-dotierte Wannen für entsprechende Transistoren hergestellt werden, bei dem Feldoxidbereiche und bei dem isolierte Gateelektroden der MOS-Transistoren hergestellt werden.

Ein derartiges Verfahren ist beispielsweise aus der EP-A-0 227 970 bekannt. Die Herstellung von Vorrichtungen mit bipolaren und MOS-Transistoren ist typischerweise aufwendig und kompliziert, da insbesondere Transistoren für die Analogsignalverarbeitung andere Eigenschaften als Transistoren für die Digitalsignalverarbeitung haben müssen. Deshalb werden mit einer Vielzahl von Masken die aktiven Bereiche der bipolaren und der MOS-Transistoren entsprechend der zu erzielenden Eigenschaften hergestellt. Weitere Masken sind erforderlich, wenn zusätzlich ein Widerstand oder eine Kapazität integriert werden sollen. Der Anschluß der aktiven Transistorbereiche an die zugehörigen Metallisierungsleitungen muß dabei so gestaltet werden, daß eine zuverlässige und niederohmige Verbindung erzielt wird.

Der Erfindung liegt die Aufgabe zugrunde, das Herstellverfahren für eine Vorrichtung mit MOS- und Bipolartransistoren zu verbessern.

Diese Aufgabe wird mit den Merkmalen des Patentanspruchs 1 gelöst.

Die Erfindung hat den Vorteil, daß nach einer Kanalimplantation für die MOS-Transistoren eine Siliziumschicht ganzflächig abgeschieden und dotiert werden kann und daß danach mit einer einzigen Strukturierungsmaske gleichzeitig die p⁺-Source- und Drain-Zonen, der Basiskontakt eines bipolaren npn-Transistors, Kollektor und Emitter eines pnp-Transistors und ggf. Elemente für passive Bauelemente hergestellt werden können. Mit einer weiteren Siliziumschicht anderer Dotierung lassen sich mit einer weiteren einzigen Maske gleichzeitig die n⁺-Source- und Drain-Zonen, der Emitter und der Kollektoranschluß eines npn-Bipolartransistors, die Basis eines pnp-Transistors und ggf. weitere Elemente für passive Bauelemente herstellen. Nach weiteren Verfahrensschritten ist es möglich, alle für eine Konktaktierung vorgesehenen Gebiete der Siliziumschichtgebiete gegeneinander zu isolieren und freizulegen, um danach eine Silizierung durchzuführen. Auf die Silizidbereiche kann anschließend eine Metallisierungsschicht, beispielsweise aus Aluminium aufgebracht werden. Dadurch ergeben sich niederohmige und zuverlässige aktive und passive Bauelementanschlüsse.

Weiterbildungen der Erfindung sind in Unteransprüchen gekennzeichnet.

Die Erfindung wird nachfolgend anhand eines in den Figuren der Zeichnung dargestellten Ausführungsbeispiels näher erläutert. Es zeigen:
- FIG 1 bis 5: Querschnitte durch eine Halbleiterscheibe mit einem herzustellenden p-Kanal-MOS-Transistor,
- FIG 6: Querschnitte durch eine Halbleiterscheibe für einen p-Kanal- sowie einen n-Kanal-MOS-Transistor,
- FIG 7: Querschnitte durch eine Halbleiterscheibe mit einem npn- bzw. pnp-Transistor,
- FIG 8: Querschnitte durch eine Halbleiterscheibe mit einem Widerstand und einer Kapazität.

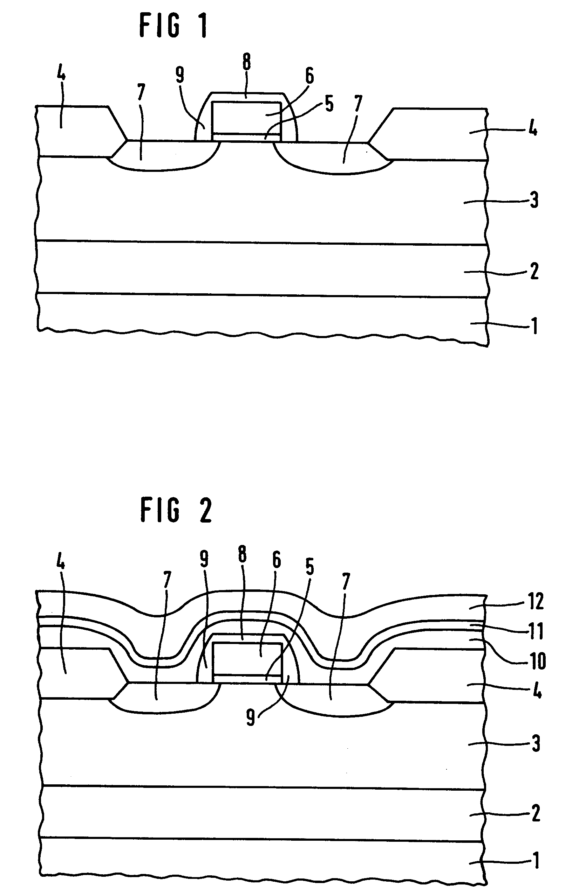

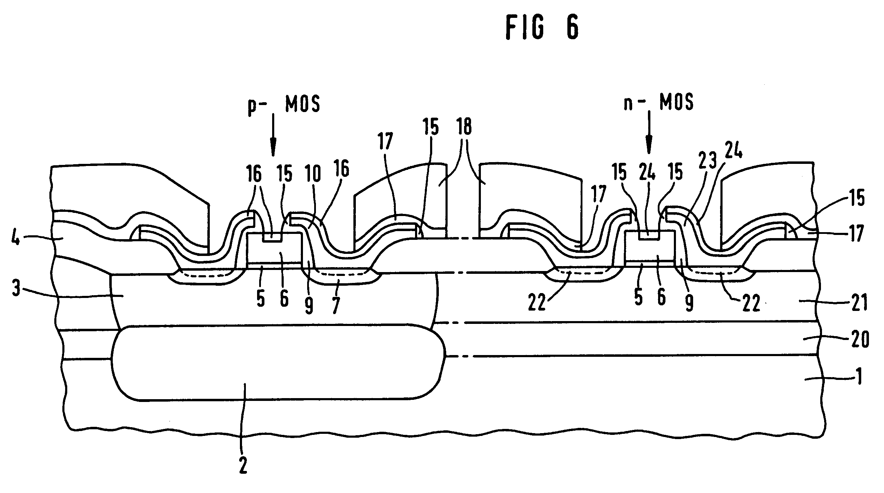

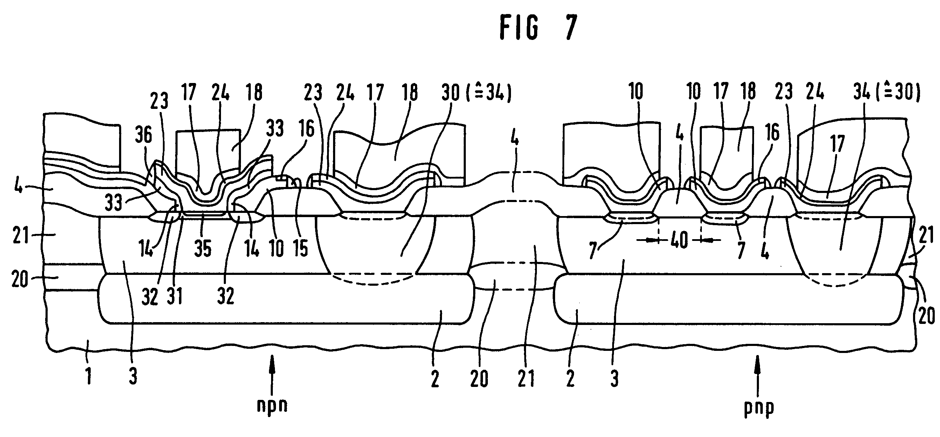

Gemäß Figuren 1 und 6 bis 8 werden auf einem p-dotierten Substrat 1 zunächst eine n⁺-dotierte vergrabene Schicht 2 und eine in den FIG 6 und 7 dargestellte p⁺-dotierte vergrabene Schicht 20 erzeugt, die sich an die Schicht 2 anschließt. Anschließend wird ganzflächig eine epitaktische Schicht aufgebracht, in der n-Wannen 3 sowie p-Wannen 21 (FIG 6, 7) erzeugt werden. Dabei können unterschiedlich dotierte n-Wannen für einerseits die zu erzeugenden Bipolartransistoren mit Analogeigenschaften und andererseits die MOS-Transistoren sowie die Bipolartransistoren mit Digitaleigenschaften erzeugt werden. Anschließend werden durch lokale Oxidation Feldoxidbereiche 4 zur Isolation der zu erzeugenden aktiven Elemente erzeugt. Es folgt eine Maskierung mit anschließender n⁺-Implantation zur Herstellung eines hochleitfähigen Bereichs zwischen der Oberfläche der Halbleiterscheibe und der vergrabenen Zone 2. Dadurch werden beim vertikalen npn-Transistor die Kollektorzone 30 und beim lateralen pnp-Transistor die Basiszone 34 (siehe FIG 7) hergestellt.

Nach Ablösen der Lackmaske und einem Ausheilprozeß folgt eine ganzflächige Implantation mit p-Dotierung. Als nächstes folgt eine Fototechnik bzw. Maskierung und unter Verwendung der Maske eine Dotierung zur Einstellung der Schwellenspannungen der MOS-Transistoren (Threshold-Maske). Es schließt sich das Aufbringen einer Gate-Isolationsschicht, einer darüberliegenden polykristallinen Schicht, die dotiert ist oder wird, und einer auf dieser liegenden Isolationsschicht, beispielsweise einer durch ein LPCVD-Verfahren (low pressure chemical vapor deposition) aufgebrachten TEOS-Schicht an. Letztere dient zur Isolation der darunterliegenden Polysiliziumschicht gegen weitere, mit nachfolgenden Verfahrensschritten aufzubringende Polysiliziumschichten. Als nächstes wird mit einer Fototechnik eine Strukturierung der obenliegenden Isolationsschicht und der Polysiliziumschicht zur Herstellung der Gates der MOS-Transistoren vorgenommen.

Mit einer weiteren Fototechnik und anschließender Implantation mit einem n-leitenden Material, beispielsweise Phosphor, werden LDD-Gebiete (Lightly Doped Drain-Gebiet) der n-Kanal-Transistoren durch eine Überkompensation der zuvor vorgenommenen ganzflächigen p-Dotierung (vor der Threshold-Maske) erzeugt. Nach einem Auftrag einer Isolierschicht, beispielsweise LPCVD-TEOS schließt sich eine Rückätzung zur Bildung von lateralen Isolationsstege (Spacer) an. Es ergibt sich die Struktur gemäß FIG 1, in der die n-Wanne 3 LOCOS-Gebiete 4 enthält, zwischen denen die Gate-Isolation 5 und das Gate 6 sowie eine darüberliegende Isolationsschicht 8 angeordnet sind. An den Seiten wird das Gate durch Spacer 9 isoliert, so daß das Gate ganzseitig von einer Isolationsschicht umschlossen ist. Zwischen dem Gate und den LOCOS-Gebieten 4 sind LDD-Gebiete 7 angeordnet. Bei einem p-Kanal-Transistor sind die LDD-Gebiete 7 p-dotiert, wahrend sie bei einem n-Kanal-Transistor n-dotiert sind. In Anordnungen ohne LDD-Gebiete werden nach der Strukturierung des Gates gleich die lateralen Isolationsstege erzeugt.

Als nächstes wird ganzflächig eine erste Siliziumschicht 10, beispielsweise aus Polysilizium oder amorphen Silizium mit der Dicke 200 nm abgeschieden und mit p-Atomen hoch dotiert, Fig. 2. Es folgt bei der amorphen Siliziumschicht eine Rekristallisation. Danach folgt eine Belegung mit Oxid bei einer Temperatur von 700 bis 800 °C. Das Oxid wird anschließend geätzt und eine Nitridbeschichtung 11 der Dicke 20 bis 50 nm vorgenommen. (In Bereichen, in denen eine Kapazität erzeugt werden soll, kann diese Nitridbeschichtung 11 auf der nunmehr kristallinen Polysiliziumschicht 10 das Dielektrikum bilden.) Danach wird eine Isolierschicht, beispielsweise eine TEOS-Schicht 12 durch eine Niederdruckabscheidung aus der Gasphase (LPCVD) aufgebracht. Nitridschicht 11 und Oxidschicht 12 bilden eine Hilfsschicht. Es folgt ein Ausheilen der Anordnung bei etwa 800 °C.

Zu ergänzen ist, daß nach Abscheidung der ersten Siliziumschicht 10 eine Option zur Herstellung eines Hochohmwiderstands möglich ist, bei der die Siliziumschicht zunächst ganzflächig niedrig p-dotiert wird, beispielsweise durch Bor, und danach eine Fototechnik mit anschließender hochdotierter p-Implantation der Nicht-Hochohmwiderstandsbereiche sowie eine Ablösung der Fotolackmaske erfolgt.

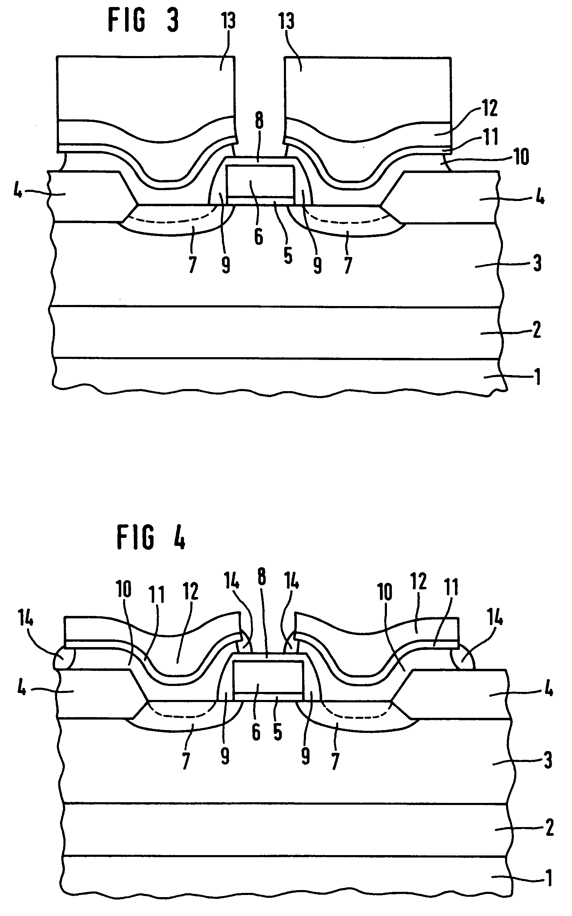

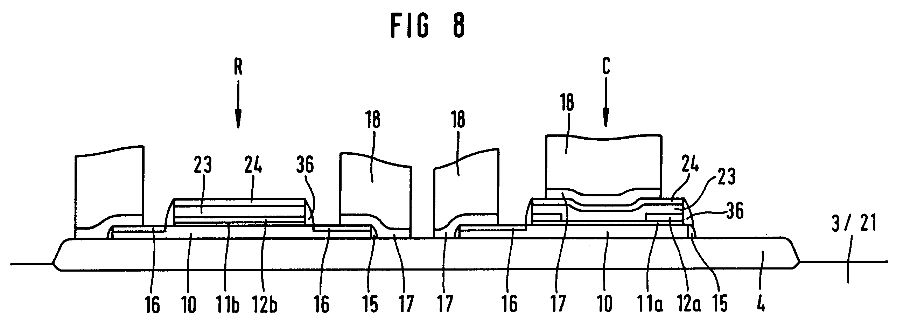

Eine einzige weitere Fototechnik bereitet die Herstellung der Basiszone für den bipolaren npn-Transistor, der p⁺-Source/Drain-Kontaktbereiche des p-Kanal-MOS-Transistors, der Kollektor- und Emitterzone des pnp-Transistors sowie optional des Hochohmwiderstands R und einer Elektrode der Kapazität C (FIG 8) vor. Gemäß FIG 3 werden nach der Strukturierung der Maske 13 die Oxidschicht 12 und die darunterliegende Nitridschicht 11 geätzt. Es schließt sich eine Ätzung der ersten Siliziumschicht 10 an. Ein Vorteil des Verfahrens besteht darin, daß der MOS-Herstellungsprozeß nicht vom Prozeß der Herstellung der bipolaren Transistoren getrennt ist, sondern daß Prozeßschritte zur gleichzeitigen Herstellung von Elementen der bipolaren und der unipolaren Transistoren eingesetzt werden. Deshalb kommt das Verfahren zur Herstellung einer Struktur gemäß FIG 3 mit maximal 10 Masken aus.

Mit der ersten Maske wird die n⁺-vergrabene Zone 2 erzeugt, mit den Masken 2 und 3 die n-Wannen für den CMOS- bzw. den bipolaren Digitaltransistor sowie den bipolaren Analogtransistor, mit Maske 4 die Feldoxidbereiche durch lokale Oxidation, mit Maske 5 der Kollektor- bzw. Basistiefanschluß für den npn- bzw. den pnp-Transistor, mit Maske 6, die Schwellenspannungen, mit Maske 7 die Gates der MOS-Transistoren, mit Maske 8 die LDD-Bereiche der n-Kanal-MOS-Transistoren, mit Maske 9 wahlweise der Hochohmwiderstand und schließlich mit Maske 10 die beschriebenen Elemente Basiskontakt für den npn-Transistor, die Source-/Drain-Bereiche für den p-Kanal-MOS-Transistor, die Emitter-/Kollektorzonen für den pnp-Transistor sowie Elemente des Widerstandes und der Kapazität.

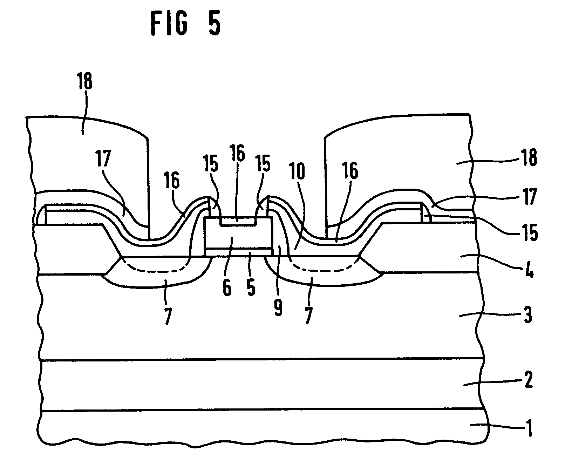

Nach der Ätzung der Siliziumschicht 10 folgt eine Belegung mit einem Streuoxid und eine ganzflächige Implantation von p-Atomen, beispielsweise Bor, zur Herstellung der Basiszone 31. Die Basiskontaktzone 32 des npn-Transistors, die Source/Drain-Zonen für den p-MOS-Transistor und die Kollektor- und Emitterzonen für den pnp-Transistor werden durch Ausdiffusion aus der strukturierten und dotierten Schicht 10 erzeugt. Danach wird eine Isolationsschicht 33, beispielsweise aus LPCVD-TEOS aufgetragen und rückgeätzt, um die strukturierten Siliziumgebiete 10 an ihrer Oberfläche (Schicht 33) und seitlich mit lateralen Isolationsstegen 14 zu isolieren, FIG 4, FIG 7 (npn-Transistor).

Wenn die Option zur Herstellung einer Kapazität wahrgenommen werden soll, bei der die Nitridschicht 11 das Dielektrikum bilden soll, wird gemäß FIG 8 im Bereich der Kapazität mit Hilfe einer Fototechnik die Oxidschicht 12 strukturiert, so daß sich ein strukturierter Oxidbereich 12a über einem aus der Nitridschicht 11 hergestellten Dielektrikumsbereich 11a ergibt. Die Lackmaske wird anschließend abgelöst. Beim Widerstand R als anderem passiven Bauelement sind die Nitrid- und Oxidschichten 11 und 12 in der zuvor beschriebenen Weise strukturiert und als Schichten 11b bzw. 12b bezeichnet. Beim Widerstand R kann die Nitridschicht 11b entfallen und nur die Oxidschicht 12b vorgesehen sein.

Im nächsten Schritt wird eine kristalline Polysiliziumschicht 23 erzeugt und ganzflächig mit einem n-leitenden Material, beispielsweise Arsen, implantiert. Es schließt sich eine Strukturierung der Polysiliziumschicht 23 mit Hilfe einer Fototechnik an, um durch einen Diffusionsschritt die Kontaktzonen 35 für den Emitteranschluß und den Kollektoranschluß des npn-Bipolartransistors, für den Basisanschluß des pnp-Transistors (FIG 7), für die n⁺-dotierten Source-/Drain-Zonen 22 des n-Kanal-MOS-Transistors (FIG 6), für die zweite Elektrode der Kapazität C und optional zur Abdeckung der Isolationsschicht 12b des Widerstands R (FIG 8) zu erzeugen. Anschließend wird der Fotolack abgelöst. Auch hier werden wieder für die Bipolar- und MOS-Transistoren gleichzeitig die beschriebenen Prozeßschritte durchgeführt.

Als Option kann sich die Herstellung eines Kontaktlochs anschließen. Dazu wird zunächst eine Isolationsschicht, beispielsweise aus LPCVD-TEOS und eine darüberliegende Borphosphor-Silikatglasschicht (BPSG) aufgetragen. Nach einem Verfließschritt schließt sich eine Fototechnik für das Kontaktloch mit anschließender Kontaktlochätzung durch ein anisotrop wirkendes Ätzmittel an. Nach Ablösen des Lacks und ggf. einer Nachbehandlung in einer Gasatmosphäre sind die Kontaktlöcher zu den strukturierten Polysiliziumschichten 10 bzw. 23 hergestellt. Die Kontaktlöcher können auch für eine für die Anordnung geplante Mehrlagenverdrahtung vorgesehen sein.

Mit den bisherigen Verfahrensschritten sind alle Kontaktanschlüsse für die aktiven Gebiete der Transistoren und für die Anschlüsse der passiven Bauelemente hergestellt. Die eigentlichen Anschlüsse sind aus der jeweiligen Wanne herausgezogen und der Kontakt zu den aktiven Gebieten im Monosilizium der Wannen erfolgt durch Ausdiffusion aus der jeweiligen Polysiliziumschicht in das aktive Gebiet, d.h. bei den MOS-Transistoren in die LDD-Gebiete 7 bzw. 22. In FIG 6 sind die durch die Diffusion entstandenen hochdotierten Gebiete der p-Zonen 7 und der n-Zonen 22 gestrichelt eingezeichnet.

Durch die gemeinsame Herstellung des npn-Emitteranschlusses, des pnp-Basisanschlusses und der n⁺-dotierten Source/Drainzonen des n-Kanal-Transistors (Gebiete 22) kann gegenüber bisheriger Herstelltechnologien mit getrennten Herstellschritten für den bipolaren und für den MOS-Transistor wiederum eine Maske eingespart werden, so daß für diese Kontaktanschlüsse eine einzige Maske ausreicht.

Gemäß eines Aspekts der Erfindung schließt sich an die Herstellung der strukturierten Bereiche 23 die Herstellung der Metallisierungsschicht an. Herzu sieht die Erfindung vor, das zunächst die Siliziumgebiete 10 und 23 seitlich isoliert werden. Dazu wird eine Isolierschicht, beispielsweise in LPCVD-TEOS aufgebracht, ausgeheilt durch rapid optical annealing (ROA) und so zurückgeätzt, daß laterale Isolationsstege bzw. Spacer 15 bzw. 36 an den Seitenbereichen der Siliziumschichten 10 bzw. 23 gebildet werden und die Siliziumschichten 10 und 23 im übrigen an ihrer Oberfläche freiliegen. Dies gilt sowohl für die Transistoren als auch für die passiven Bauelemente R und C. Ebenso gilt dies für die Gatebereiche der MOS-Transistoren, die durch die Spacer 15 ein Fenster bis in das Polysiliziumgebiet 6 freilassen. Anschließend werden die an ihrer Oberfläche freiliegenden Siliziumgebiete unter Verwendung von Platin, Titan oder Tantal siliziert, so daß die Siliziumschichten 6, 10 und 23 mit Silizidbereichen 16 und 24 versehen sind. Die alternativ auf dem Widerstand R vorgesehene Siliziumschicht 23 mit ihrem Silizid 24 ist zweckmäßig, um das Hochohmgebiet durch selbstjustierte Herstellung der silizierten Anschlußgebiete 16 zu definieren und festzulegen.

Vorteile der Erfindung bestehen darin, daß aktive Bereiche durch Ausdiffusion aus dotierten und strukturierten Siliziumschichten gleichzeitig für bipolare und für MOS-Transistoren erzeugt werden und daß keine Silizierung in Monosilizium, sondern nur auf Polysiliziumschichten vorgesehen ist, so daß die mit der Silizierung von Monosilizium verbundenen Schwierigkeiten nicht auftreten. Weiterer Vorteil ist, daß durch den Prozeßablauf und die Struktur der Anordnung ein Verzicht auf eine Kontaktloch-Fototechnik (Ätzprozeß) möglich ist. Die silizierten Polysiliziumschichten verringern den Flächenwiderstand um ein Vielfaches (von etwa 200 Ohm/· auf etwa 5 Ohm/·). Im Herstellverfahren schließt sich die Ablösung des nicht silizierten Metalls an. Anschließend wird als Barriereschicht 17 eine Titan, Titannitrid oder Titanwolframschicht aufgebracht und darüber eine Metallisierungsebene 18, beispielsweise aus AlSiCu. Die letzten beiden aufgetragenen Schichten werden mit Hilfe einer weiteren Fototechnik und einer nicht gezeigten strukturierten Lackmaske geätzt, so daß sich eine strukturierte Metallisierung 17, 18 ergibt. Anschließend wird der Lack abgelöst und das Verfahren zur Herstellung der integrierten Schaltung wird mit üblichen, hier nicht näher erläuterten Schritten fortgesetzt.

## Patentansprüche

1. Verfahren zur Herstellung von komplementären MOS-Transistoren und von komplementären Bipolartransistoren auf einer gemeinsamen Halbleiterscheibe, bei dem vergrabene Zonen unterschiedlicher Leitfähigkeit erzeugt werden, bei dem n- und p-dotierte Wannen für entsprechende Transistoren hergestellt werden, bei dem Feldoxidbereiche und bei dem isolierte Gateelektroden der MOS-Transistoren hergestellt werden,
**gekennzeichnet** durch folgende Schritte:
- nach der Herstellung der Feldoxidbereiche (4) werden mittels einer ersten Maske hochdotierte n-Bereiche (30, 34) erzeugt, die von der Oberfläche der Halbleiterscheibe bis zu einer jeweiligen vergrabenen n-dotierten Zone (2) reichen, um eine Kollektorzone (30) eines npn-Transistors und eine Basiszone (34) eines pnp-Transistors zu erzeugen;
- nach der Herstellung der isolierten Gate-Elektroden (6) wird ganzflächig eine erste Siliziumschicht (10) aufgebracht und mit p-Atomen dotiert;
- auf der ersten Siliziumschicht wird ganzflächig eine Hilfsschicht (11, 12) aufgebracht;
- mit Hilfe einer zweiten Maske (13) werden die Hilfsschicht und die erste Siliziumschicht strukturiert;
- durch Ausdiffusion aus der strukturierten ersten Siliziumschicht werden gleichzeitig eine Basiskontaktzone (32) des npn-Transistors, die Source- und die Drainzone eines p-MOS-Transistors und eine Kollektor- und eine Emitterzone des pnp-Transistors erzeugt;
- die erste Siliziumschicht (10) wird seitlich (14) isoliert und eine zweite Siliziumschicht (23) wird erzeugt, mit n-Atomen dotiert und mit Hilfe einer Maske strukturiert;
- durch Ausdiffusion aus der strukturierten zweiten Siliziumschicht werden gleichzeitig die Emitterzone (35) und die Kollektoranschlußzone des npn-Transistors, der Basisanschluß des pnp-Transistors und die Source- und die Drainzone eines n-MOS-Transistors erzeugt.

2. Verfahren nach Anspruch 1,
**dadurch gekennzeichnet,** daß als erste Siliziumschicht (10) eine amorphe Siliziumschicht aufgebracht wird, die nach der Dotierung mit p-Atomen rekristallisiert wird.

3. Verfahren nach Anspruch 1 oder 2,
**dadurch gekennzeichnet,** daß nach der Strukturierung der ersten Siliziumschicht (10) eine ganzflächige Dotierung mit p-Atomen zur Erzeugung einer Basiszone (31) für den npn-Transistor erfolgt.

4. Verfahren nach Anspruch 1,
**dadurch gekennzeichnet,** daß vor dem Aufbringen der ersten Siliziumschicht eine niedrige Dotierung der für Source- und Draingebiete (7, 22) der MOS-Transistoren (p-MOS, n-MOS) vorgesehenen Zonen der Halbleiterscheibe erfolgt.

5. Verfahren nach einem der Ansprüche 1 bis 4,
**dadurch gekennzeichnet,** daß die Dotierung der ersten Siliziumschicht (10) in nicht maskierten Bereichen erfolgt und daß entsprechend die maskierten Bereiche in einem vorangehenden Schritt mit einem zweiten p-leitenden Material niedriger dotiert werden als für die nicht maskierten Bereiche vorgesehen ist (R), und daß nach der Dotierung der nicht maskierten Bereiche der ersten Siliziumschicht die maskierten Bereiche freigelegt werden.

6. Verfahren nach einem der Ansprüche 1 bis 5,
**dadurch gekennzeichnet,** daß bei der Strukturierung der ersten Siliziumschicht (10) die Bildung einer ersten Kapazitätselektrode vorgesehen ist, daß die erste Siliziumschicht nach ihrer Strukturierung laterale Isolationsstege (15) erhält, daß eine weitere Strukturierungsmaske zur weiteren Strukturierung der Hilfsschicht (11, 12) auf der ersten Kapazitätselektrode (c) erzeugt wird, daß die Hilfsschicht (11, 12) teilweise entfernt wird und daß nach der Entfernung der weiteren Strukturierungsmaske die zweite Siliziumschicht (23) aufgebracht, dotiert und zur Bildung einer zweiten Kapazitätselektrode (C, 23, 24) strukturiert wird.

7. Verfahren nach eine der Ansprüche 1 bis 6,
**dadurch gekennzeichnet,** daß die erste und die zweite Siliziumschicht (10, 23) gegeneinander und gegen die Gateelektroden (6) der MOS-Transistoren isoliert sind und daß die Oberflächen in der ersten und der zweiten Siliziumschicht freigelegt und siliziert werden.
